(19) Europäisches Patentamt
European Patent Office
Office européen des brevets

(11) Publication number : **0 448 285 B1**

(12) # EUROPEAN PATENT SPECIFICATION

(45) Date of publication of patent specification : **11.10.95 Bulletin 95/41**

(51) Int. Cl.$^6$ : **G03F 7/075,** C08G 77/24, // H01L21/475

(21) Application number : **91302144.0**

(22) Date of filing : **13.03.91**

(54) **Photosensitive resins comprising poly(siloxane) derivatives.**

(30) Priority : **14.03.90 JP 63413/90**

(43) Date of publication of application : **25.09.91 Bulletin 91/39**

(45) Publication of the grant of the patent : **11.10.95 Bulletin 95/41**

(84) Designated Contracting States : **DE FR GB**

(56) References cited :
**EP-A- 0 231 497**
**EP-A- 0 255 303**
**CHEMICAL ABSTRACTS, vol. 110, no. 14, April 3, 1989, Columbus, Ohio, USA, TOSHIBA CORP. "Photoresist compositions"**
**CHEMICAL ABSTRACTS, vol. 113, no. 4, July 23, 1990, Columbus, Ohio, USA, OKI ELECTRIC INDUSTRY CO., LTD. "Photosensitive resin compositions for fine patterning"**

(73) Proprietor : **Oki Electric Industry Co., Ltd.
7-12, Toranomon 1-chome
Minato-ku
Tokyo (JP)**

(72) Inventor : **Sakata, Miwa, c/o Oki Electric Industry Co. Ltd.
7-12, Toranomon 1-chome
Minato-ku, Tokyo (JP)**
Inventor : **Ito, Toshio, c/o Oki Electric Industry Co. Ltd.
7-12, Toranomon 1-chome
Minato-ku, Tokyo (JP)**

(74) Representative : **Read, Matthew Charles et al
Venner Shipley & Co.
20 Little Britain
London EC1A 7DH (GB)**

EP 0 448 285 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

This invention relates to a photoresist material adapted for use in the fabrication of semiconductor devices and the like.

In the fabrication of semiconductor devices, it is essential to process a substrate. For the formation of a metal wiring pattern used in integrated circuits, for example, there is usually used a procedure which comprises forming a metal film for wiring over an entire surface of a substrate to be processed, forming a resist film on the metal film, subjecting the resist film to exposure to light and development thereby forming a resist pattern, etching the metal film through the resist pattern mask, and removing the resist pattern.

A recent trend toward a high degree of integration and a high working speed of IC leads actually to adoption of superfineness of a wiring pattern and a multi-layered wiring. In order to lower the resistance of the wiring in the superfineness, there is a tendency that an aspect ratio of the pattern is increased, resulting in a greater step on the substrate to be processed. This will produce the following problem when a resist pattern is formed on the substrate. Since the step may become greater than a focal depth of a scaling-down projection exposure device, it will become difficult to form a resist pattern with an intended size by the use of the projection exposure device. Especially, when patterning in a submicron area is perfomed, a scaling-down projection exposure device having lenses with a larger numerical aperture has to be used, so that the focal depth becomes smaller. Thus, the problem on the step become more pronounced, with the possibility that any pattern cannot be formed using only one resist layer as in prior art.

To overcome the above difficulty, there is known a technique as disclosed, for example, in Journal of Electrochemical Society: SOLIDSTATE SCIENCE AND TECHNOLOGY 132 (5)(1985.5) PP. 1178-1182. This technique is a resist pattern forming technique called a two-level resist process wherein a resist of a positive type having sensitivity in a deep UV range (200 to 300 nm) is used.

The two-level resist process is described below. Initially, a thermosetting resin is formed on a stepped substrate to be processed as a thick layer and thermally set to planarize the substrate. Thereafter, a very thin layer of a photosensitive resin which is highly resistant to oxygen plasma etching is fomed on the planarized surface, followed by subjecting the photosensitive resin layer to exposure and development to form a pattern. Subsequently, the thermoset resin layer is etched through the pattern as a mask by reactive ion etching using oxygen gas ($O_2$-RIE), thereby obtaining a two-layered resist pattern having a high aspect ratio. Further, the two-layered resist pattern is used as a mask for etching an underlying metal layer on the substrate to be processed.

One of advantages of the two-level resist process resides in that since the pattern of the photosensitive resin layer is formed on the thick planarizing layer, it does not suffer any influence from the substrate, so that a fine pattern with a high aspect ratio can be formed without any dimensional change.

The resist material used to form the photosensitive resin layer is one which contains silicon. According to the above literature, there is shown a (trimethylsilymethyl methacrylate-3-oximino-2-butanone methacrylate) copolymer. This resist is sensitive to deep-UV to delineate a pattern of 1$\mu$ m lines and spaces at an exposure does of 250 mJ/cm$^2$ and has minimum resolving power of 0.75 $\mu$m lines.

However, the above resist has such a low silicon content of 9.6 wt%, with the problem that the etching rate by $O_2$-RIE becomes so high as 15 nm/minute, i.e. the resistance to $O_2$-RIE is low. Another problem is that the resolving power is not satisfactory.

It is accordingly an object of the invention to provide a photosensitive resin which is useful as a resist material and which overcomes the problems involved in the prior art resins.

It is another object of the invention to provide a photosensitive resin which has good film properties and a good processing accuracy.

It is a further object of the invention to provide a photosensitive resin which is comprised of a poly(siloxane) derivatives having specific types of groups therein.

The above objects can be achieved, according to the invention, by a poly(siloxane) derivative which comprises siloxane units having at least one functional group selected from the group consisting of an unsaturated group, an alkyl group and a halogenated alkyl group and terminated with a polysilanyl group.

As defined above, the poly(siloxane) derivatives according to the invention should have siloxane units having at least one functional group selected from an unsaturated group, an alkyl group and a halogenated alkyl group and terminated with a polysilanyl group.

Preferably, the unsaturated group is an unsaturated hydrocarbon group such as a vinyl group ($CH_2$=CH-), an allyl group ($CH_2$=$CHCH_2$-), an isopropenyl group ($CH_2$=C-$CH_3$) or a 2-butenyl group ($CH_2$=CH-$CH_2$-$CH_2$-), and the alkyl group has not larger than 4 carbon atoms and include, for example, a methyl group, an ethyl group, an n-propyl group, an iso-propyl group, an n-butyl group, an iso-butyl group and a tert-butyl group. The halogenated alkyl group should preferably have an alkyl group having not larger than 4 carbon atoms and substituted

with at least one halogen such as chlorine, bromine or iodine. Specific examples include a chloromethyl group, a chloroethyl group, a chloropropyl group, a chlorobutyl group, a bromomethyl group, a bromoethyl group, a bromopropyl group, a bromobutyl group, an iodomethyl group, an iodoethyl group, an iodopropyl group and an iodobutyl group provided that the halogen atoms may be substituted to a full extent depending on the type of alkyl moiety. For instance the chloromethyl group may include mono, di, tri and tetrachloro-substituted groups.

Preferable poly(siloxane) derivatives of the invention are of the following formula (1) or (2)

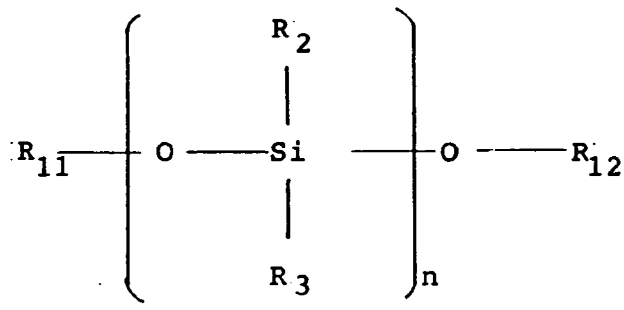

(1)

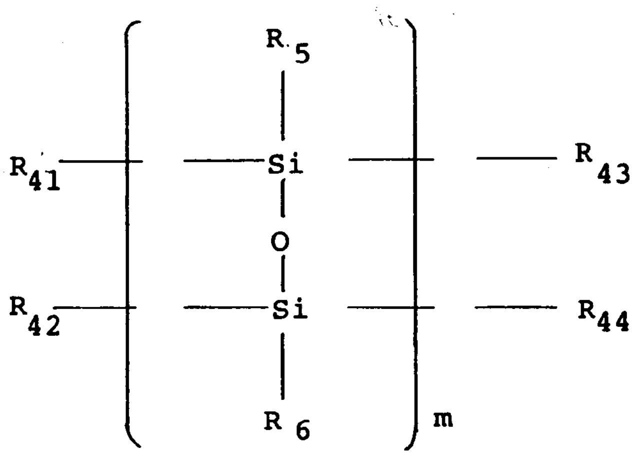

(2)

wherein $R_{11}$ and $R_{12}$ are, respectively, a polysilanyl group and may be the same or different, $R_2$ and $R_3$ are, respectively, a member selected from the group consisting of an unsaturated group, an alkyl group and a halogenated alkyl group and may be the same or different, n is a positive interger, $R_{41}$, $R_{42}$, $R_{43}$ and $R_{44}$ are, respectively, a polysilanyl group and all or part thereof may be the same or different, $R_5$ and $R_6$ are, respectively, a member selected from the group consisting of an unsaturated group, an alkyl group and a halogenated group and may be the same or different, and m is a positive interger.

In the above formulas, the unsaturated group, alkyl group and halogenated alkyl group represented by $R_1$, $R_2$, $R_3$ and $R_4$ may be the same as defined before.

The polysilanyl group should preferably be one of the following formula (3) or (4)

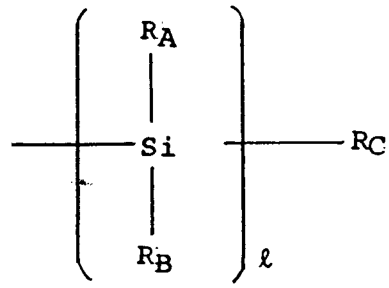

(3)

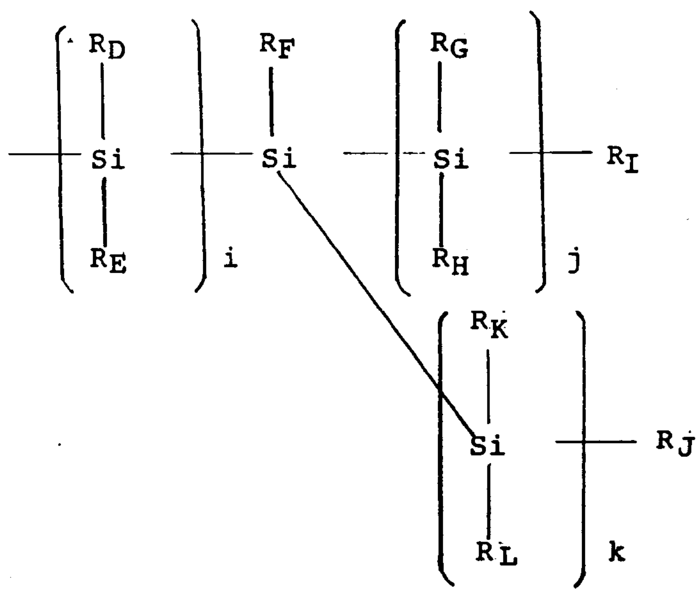

(4)

wherein $R_A$, $R_B$, $R_D$, $R_E$, $R_F$, $R_G$, $R_H$, $R_K$, and $R_L$ are respectively, a group selected from the group consisting of the following groups (a) to (e) and all or part thereof may be the same or different

(a) a linear, branched or cyclic alkyl group having not larger than 10 carbon atoms,
(b) an unsubstituted phenyl group,
(c) an unsubstituted naphthyl group,
(d) a phenyl group having one group selected from the group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom; and $R_C$, $R_I$ and $R_J$ are, respectively, a radical selected from the group consisting of the following groups (f) to (k) and all or part thereof may be the same or different
(f) an alkyl group having not larger than 10 carbon atoms,
(g) an unsubstituted phenyl group,
(h) an unsubstituted naphthyl group,
(i) a phenyl group having one group selected from the group consisting of a nitro group, an alkoxy group, and a halogen atom, and
(j) a naphthyl group having one group selected from the group consisting of a nitro group, an alkoxy group, and a halogen atom, and
(k) an alkoxy group having not larger than 5 carbon atoms. In the formula (3), $\ell$, which indicates the number of silicon atoms, is such an integer that $2 \leqq \ell \leqq 10$. In the formula (4), i, j and k which, respectively, indicate the number of silicon atoms, are such integers that $0 \leqq i \leqq 7$, $1 \leqq j \leqq 8$, $1 \leqq k \leqq 8$ and $i + j + K \leqq 9$.

A starting material from which poly(siloxane) derivative is prepared for use as the photosensitive resin of the invention should preferably be a linear, hydroxyl-terminated poly(siloxane) derivative of the following formula (5) or a hydroxyl-terminated polysilsesquioxane derivative of the following formula (6)

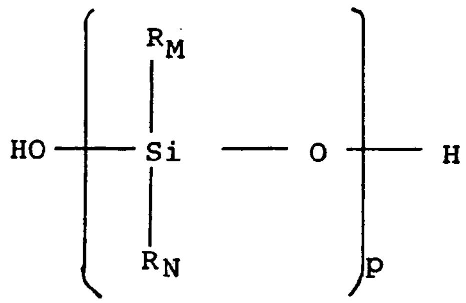

(5)

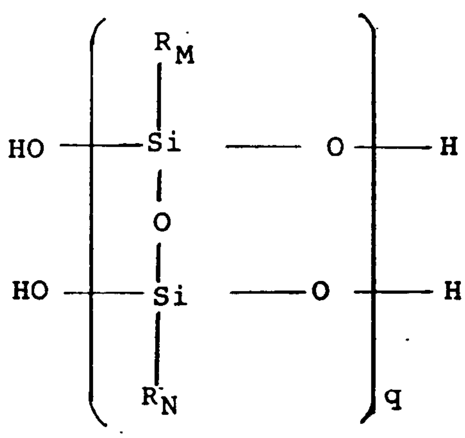

(6)

wherein $R_M$ and $R_N$ are, respectively, a functional group selected from the group consisting of an unsaturated group, an alkyl group and a halogenated alkyl group and may be the same or different, and p and q are, respectively, a positive integer. Specific examples of the group represented by $R_M$ and $R_N$ include unsaturated groups such as a vinyl group, an isopropenyl group, an allyl group and the like, alkyl groups having not larger than 4 carbon atoms, and halogenated alkyl groups having at least one substituent of chlorine, bromine or iodine and having not larger than 4 carbon atoms.

Of these starting materials, the polysilsesquioxane derivative of the formula (6) is a compound proposed by the present applicant in Japanese Laid-open Patent Application No. 63-210839, and the poly(siloxane) derivative of the formula (5) is readily obtained according to the process described in the above Laid-open Patent Application wherein starting trichlorosilane is replaced by dichlorosilane. These compounds are readily available without gelation at the stage of preparation so far as its weight average molecular weight is approximately 100,000. In this connection, however, when the weight average molecular weight is smaller than 2,000, crystallization becomes difficult, thus being unsuitable for the formation of a resist pattern. In addition, an exposure necessary for patterning becomes too great. Accordingly, the starting materials should preferably be compounds of the formula (5) or (6) with a weight average molecular weight of from 2,000 to 100,000.

These starting materials may be a base resin for resist by themselves and can constitute a resist when used along with photosensitive materials. For this purpose, it has been the common practice that the terminal OH groups are protected with an inactive group such as a trimethylsilyl group in consideration of storage stability. The photosensitive resin according to the invention significantly differs from the prior art resins in that the terminal OH groups of the starting materials are modified with a polysilanyl group and that any photosensitive agent is not necessary.

The photosensitive resin of the invention can be prepared by reacting such a starting material as stated above with a monofunctional polysilane such as, for example, monochlorosilane in the presence of a basic catalyst. Examples of the basic catalyst include triethylamine, tri-n-butylamine, pyridine, lutidine, γ-collidine, imidazole and the like. The reaction is effected in a solvent and examples of such solvents include tetrahydrofuran, dimethylformamide, dimethylsulfoxide, 1, 4-dioxane, methyl ethyl ketone, methyl isobutyl ketone, toluene and the like.

For the preparation, the polysilane is used in such an amount that the molecules of the polysilane are greater in number than the number of OH groups in the starting material. Although depending on the number average molecular weight of the starting material, the amount is generally in the range of from 3 to 50 mol%. The amount of the basic catalyst is in the range of one to ten times the amount of the polysilane. It will be noted that any monofunctional polysilanes are usable in the practice of the invention and specific examples are mentioned in examples appearing hereinafter.

As will be apparent from the above, the photosensitive resin according to the invention has both at least one group selected from the group consisting of an unsaturated group, an alkyl group and halogenated alkyl group and a polysilanyl end group in the molecule. The polysilanyl group of the photosensitive resin is able to absorb a deep UV with a wide wavelength of from 200 to 400 nm by changing the structure (e.g. the absence or presence of branching), the number of silicon atoms in the polysilanyl group and the type of substituent of the polysilanyl group. Upon reception of the deep UV light, active species such as a silyl radical or a silylene are produced. For instance, with the polysilanyl group having such a structure as indicated by the afore-indicated formula (3) or (4), when they receive light with a wavelength ranging from 200 to 400 nm, active species such as a silyl radical, silylene and the like are efficiently generated in view of the number of silicon atoms and the types of substituents. When the photosensitive resin has an unsaturated group, the active species are added to the unsaturated group to start polymerization. Alternatively, when the photosensitive resin has an alkyl group and/or a halogenated alkyl group, the active species act to withdraw the hydrogen from the alkyl group or the halogen from the halogenated alkyl group, polymerization is commenced. The portion of the photosensitive resin which has undergone the polymerization becomes insoluble in organic solvents. Accordingly, when light is selectively irradiated on the photosensitive resin, a desired reisit pattern is obtained.

The poly(siloxane) or polysilsesquioxane which is a fundamental skelton of the photosensitive resin has at least ten and several percent by weight of silicon, so that the resultant resin is resistant to $O_2$-RIE.

The present invention is described by way of examples, which should not be construed as limiting the present invention. Some chemicals used in the examples may not be set forth with respect to sources thereof but those used are all chemically pure and readily abailable.

Preparation of a photosensitive resin is described in this example.

Example 1

93.2 g (1 mol) of OH-terminated poly(allylsilsesquioxane) of the formula (6), wherein $R_M$ and $R_N$ are, respectively, an allyl group, was provided as a starting material. The poly(allylsilsesquioxane) had a number average molecular weight, $M_n$ = 10,000 and a weight average molecular weight, $M_w$ = 31,000.

Subseguently, the poly(allysilsesquioxane) and 26.4 g (74.6 mmols) of chloroundecamethylpentasilane of the following formula (a) were dissolved in 1.2 liters of toluene used as a solvent.

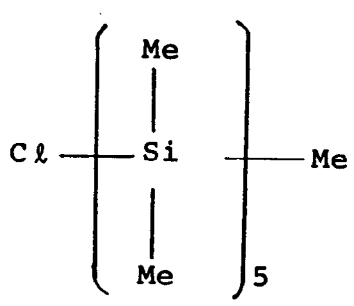

(a)

wherein Me represents a methyl group herein and whenever it appears hereinafter.

The resultant solution was agitated in an ice bath.

Thereafter, 7.5 g (74.6 mmols) of triethylamine used as a basic catalyst was dropped in the solution under agitation in an ice bath, followed by further agitation for 15 minutes.

Next, the solution was removed from the ice bath and agitated at room temperature for 3 hours. It will be noted that this time corresponds to a reaction time in Table 1.

The solution was diluted with toluene used as the solvent and filtered to remove insoluble matters therefrom. The solvent used for the dilution was distilled off, followed by repeating the dilution with the solvent, filtration of insoluble matters and removal by distillation of the solvent until any insoluble matter was observed.

After completion of the above operations, there was obtained 116.0 g of an oily matter.

116.0 g of the oily matter and 100 g of trimethylsilyl chloride in large excess were dissolved in one liter of toluene. Thereafter, 100 g of triethylamine was dropped in the solution, followed by agitation of the solution for further 5 hours to trimethylate unreacted OH groups.

As a result, there was obtained 107.0 g of a polymer, which was then diluted with the same amount of toluene, followed by dropping in 5.3 liters of methanol to obtain 73.5 g of colorless crystals (hereinafter referred to as photosensitive resin of Example 1).

The photosensitive resin of Example 1 corresponds to a poly(siloxane) derivative of the afore-indicated formula (2) wherein $R_5$ and $R_5$ are, respectively, an allyl group and $R_{41}$ to $R_{44}$ are, respectively, a polysilanyl group produced by elimination of chloraine from the chloroundecamethylpentasilane of the formula (a). It will be noted that the functional group or groups and polysilanyl group of photosensitive resins obtained in ensuing examples will be readily seen from corresponding starting materials and polysilane compounds as in Example 1 and the explanation therefor will be omitted.

Example 2 to 14

The general procedure of Example 1 was repeated except that types and amounts of starting materials, polysilane compounds, solvents and basic catalysts, thereby otaining photosensitive resins of Examples 2 to 14. In Table 1, the materials and preparation conditions used to prepare the photosensitive resin of Example 1 are also shown.

The structural formulas of the polysilane compounds used for the preparation of the respective photosensitive resins of Examples 2 to 14 are as (b) to (n) corresponding to Examples 2 to 14, respectively. In the formulas, Ph represents a phenyl group.

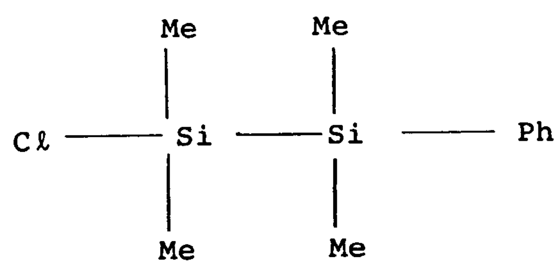

(b)

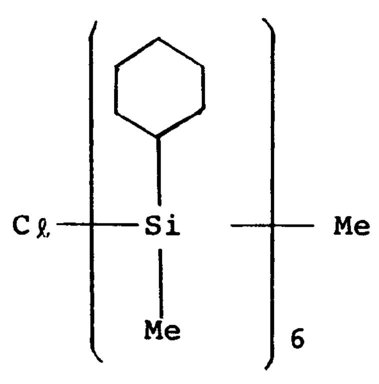

(c)

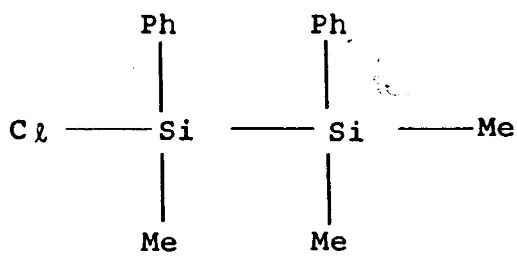

(d)

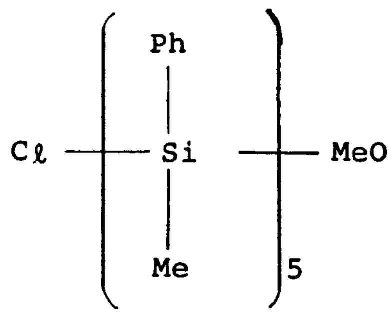

(e)

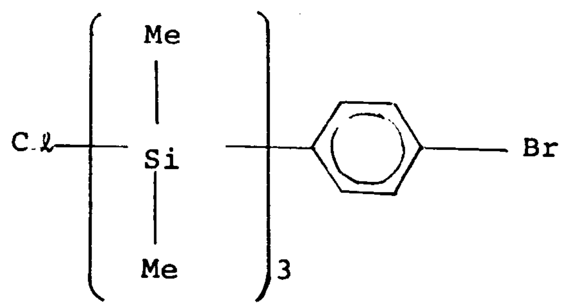

(f)

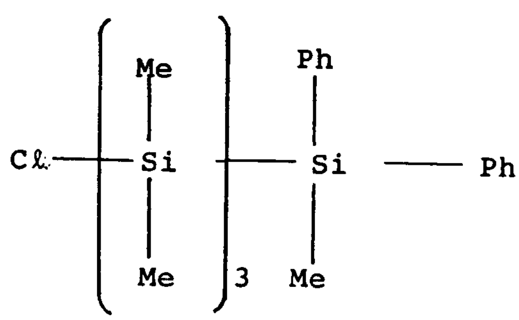

(g)

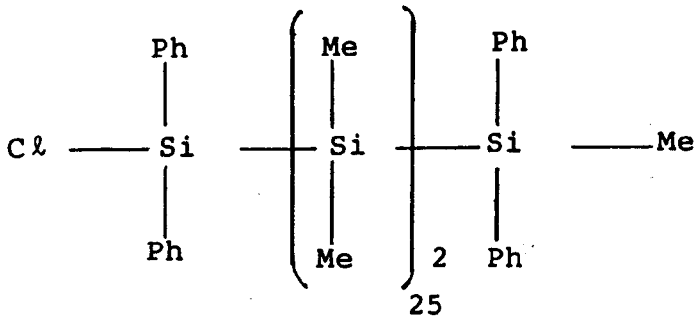

(h)

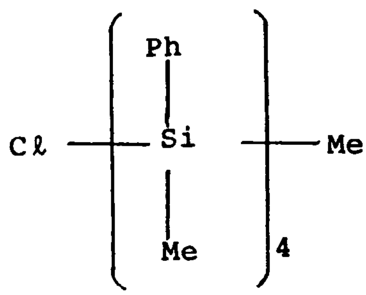

(i)

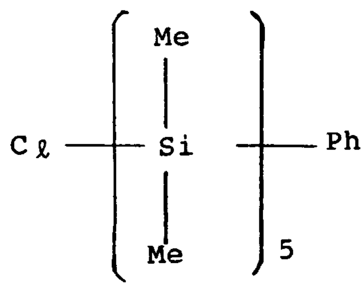

(j)

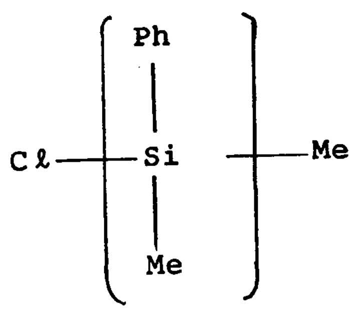

(k)

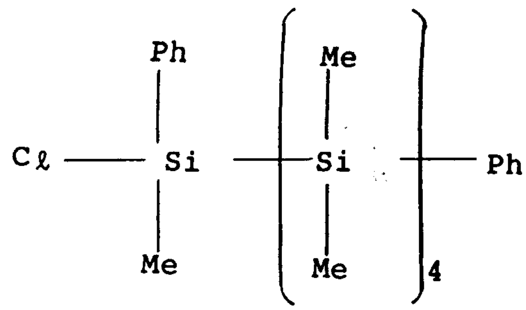

(l)

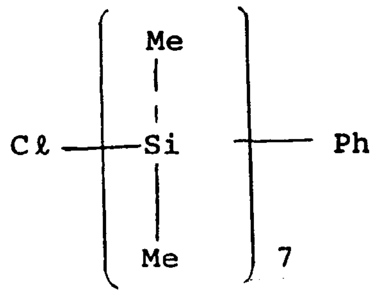

(m)

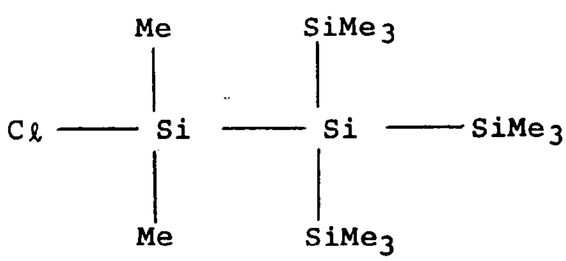

(n)

Table 1

| Example No. | Starting Material and Amount | Polysilane Compound and Amount |
|---|---|---|
| 1 | poly(allylsilsesquioxane) | chloroundecamethylpentasilane (see formula (a)) 26.4 g (74.6 mmols) |
| 2 | same as in Example 1 | chloro-2-phenyltetramethyldisilane (see formula (b)) 8.5 g (37.3 mmols) |
| 3 | poly(chloromethylsilsesquioxane) (Mn=10000, Mw=33000) | chloro-1,2,3,4,5,6-hexacyclohexylheptamethylhexasilane (see formula (c)) |
| 4 | poly(methylsiloxane) (Mn=17000, Mw=49000) 74.2 g ( 1 mol) | chloro-1,2-diphenyltrimethyldislane (see formula (d)) 7.6 g (26.2 mmols) |
| 5 | poly(vinylsiloxane) (Mn=17000, Mw=49000) 74.2 g (1 mol) | chloro-5-methoxy-1,2,3,4,5-pentaphenylpentamethylpentasilane |

| | | |
|---|---|---|
| | | (see formula (e)) 19.7 g (29 mmols) |
| 6 | same as in Example 1 | chloro-3-p-bromophenyl-hexanethyltrisilane (see formula (f)) 20.5 g (55.9 mmols) |
| 7 | same as in Example 1 | chloro-4,4-diphenyl-heptamethyltetrasilane (see formula (g)) 22.8 g (55.9 mmols) |
| 8 | same as in Example 1 | chloro-1,1,4,4-tetra-phenylpentamethyltetra-silane (see formula (h)) 29.7 g (55.9 mmols) |
| 9 | same as in Example 1 | chloro-1,2,3,4-tetra-phenylpentamethyltetra-silane (see formula (i)) 29.7 g (55.9 mmols) |

Table 1

| Basic Catalyst and Amount | Solvent and Amount | Reaction Time | Yield |
|---|---|---|---|
| triethylamine 7.5 g (74.6mmols) | toluene 1.2 liters | 3 hours | 73.5 g |
| triethylamine 3.8 g (40.6 mmols) | toluene 1.2 liters | 3 hours | 76.8 g |
| pyridine 3.2 g (40.6 mmols) | dimethylformamide 1.6 liters | 2 hours | 86.4 g |
| triethylamine 2.7 g (26.2 mmols) | methyl isobutyl ketone 0.91 liters | 5 hours | 63.0 g |
| 3,5-lutidine | tetrahydrofuran | 10 hours | 83.5 g |
| pyridine 4.4 g (55.9 mmols) | toluene 1.1 liters | 5 hours | 78.8 g |
| pyridine 4.4 g (55.9 mmols) | toluene 1.1 liters | 2 hours | 72.8 g |
| same as in Example 7 | same as in Example 7 | 2 hours | 69.4 g |
| same as in Example 7 | same as in Example 7 | 2 hours | 73.5 g |

Table 1 (Cont'd)

| Example No. | Starting Material and Amount | Polysilane Compound and Amount |
|---|---|---|
| 10 | same as in Example 1 | chloro-5-phenyldeca-methylpentasilane (see formula (j)) 22.5 g (55.9 mmols) |
| 11 | same as in Example 1 | chloro-1,2,3,4,5-pentaphenylhexamethyl-pentasilane (see formula (k)) 36.4 g (55.9 mmols) |
| 12 | sameas in Example1 | chloro-1,5-diphenyl-nonamethylpentasilane (see formula (l)) 26.0 g (55.9 mmols) |
| 13 | sameasin Example1 | chloro-7-phenyltetra-decaheptasilane (see formula (l)) 26.0 g (55.9 mmols) |
| 14 | same as in Example 1 | chloro-2,2,2-tristri-methylsilyldisilane (see formula (n)) 38.8 g (74.6 mmols) |

Table 1 (Cont'd)

| Basic Catalyst and Amount | Solvent and Amount | Reaction Time | Yield |
|---|---|---|---|
| same as in Example 7 | same as in Example 7 | 2 hours | 73.3 g |
| same as in Example 7 | same as in Example 7 | 2 hours | 74.1 g |
| same as in Example 7 | same as in Example 7 | 3 hours | 74.7 g |
| same as in Example 7 | same as in Example 7 | 3 hours | 78.9 g |
| pyridine 5.9 g (74.6 mmols) | same as in Example 7 | 3 hours | 62.5 g |

The photosensitive resins of the invention were subjected to a patterning test to determine sensitivity and resolving power of the resins.

(I) Exposure with a Xe-Hg Lamp

100 g of the photosensitive resin of Example 1 was dissolved in 730 g of xylene and the resultant solution was filtered through a membrane filter having a pore size of 0.1 μm, thereby preparing a resist of Example 1.

A photoresist (MP 2400 available from Sypray Co., Ltd.) was applied by spin coating on a silicon substrate, followed by placing the silicon substrate in an oven kept at a temperature of 200°C for 1 hour to cure the applied MP 2400 resist layer. The MP 2400 resist was applied under such conditions that thickness after the curing was 1.5 μ m. In this manner, a 1.5 μ m thick undercoating resist layer consisting of MP 2400 was formed on the silicon substrate.

Then, the resist of Example 1 was spin coated on the undercoating layer in a thickness of 0.2 μ m, followed by baking at a temperature of 80°C for 1 minute by the use of a hot plate.

Subsequently, a mask having various line and space test patterns with a minimum line width of 0.5 μ m was brought into intimate contact with the sample, followed by exposure with an exposing apparatus having a Xe-Hg lamp and a CM 250 cold mirror (PLA 501 Aligner available from Canon Inc.) while changing an exposure.

The exposed sample was immersed for development in a 1:1 (by volume) mixed solution of methyl isobutyl ketone and isoproyl alchol (IPA) for 45 seconds and was further immersed in IPA for 30 seconds and rinsed, followed by baking at a temperature of 60°C for 1 minute by the use of a hot plate.

The sample which had been developed was observed, revealing that an exposure ($D_n^{0.5}$) at which a rate of a residual film reached 50% relative to the initial thickness (0.2 μ m which is a thickness after the spin coating in this example) was 2.0 counts provided that 1 count (ct) = 39 $mJ/cm^2$. The resultant resist pattern was observed through a scanning-type electron microscope (SEM), with the result that a minimum resolution was 0.5 μ m lines and spaces (L/S) which corresponded to the minimum lines and spaces of the mask used. It will be noted that sice the minimum line width of test pattern used in this test was 0.5 μ m, a resolution of at least 0.5 μ m lines and spaces was only confirmed. In this connection, it should be appreciated that the photosensitive resin of Example 1 would have a higher resolution. This is true of the photosensitive resins of other examples.

Moreover, the photosensitive resins of Examples 2 to 14 were used to prepare the respective resists in the same manner as with the resist of Example 1. The resists of Examples 2 to 14 were, respectively, subjected to the patterning test in the same manner as with the resist of Example 1 to determine a $D_n$ value and a minimum resolution size. The results as shown in Table 2 along with thee results in the photosensitive resin of Example 1.

Table 2

| Photosensitive Resin | $D_n$ | Minimum Resolution Size ( μmL/S) |
|---|---|---|
| Example 1 | 9.4 | 0.5 |
| Example 2 | 24.1 | 0.5 |
| Example 3 | 2.3 | 0.5 |
| Example 4 | 23.2 | 0.5 |
| Example 5 | 1.8 | 0.5 |
| Example 6 | 8.0 | 0.5 |
| Example 7 | 6.2 | 0.5 |
| Example 8 | 1.7 | 0.5 |
| Example 9 | 1.2 | 0.5 |

| | | |
|---|---|---|
| Example 10 | 3.9 | 0.5 |
| Example 11 | 1.0 | 0.5 |
| Example 12 | 6.5 | 0.5 |
| Example 13 | 3.1 | 0.5 |
| Example 14 | 32.0 | 0.5 |

Moreover, the resist of Example 11 was used and subjected to exposure with a Xe-Hg lamp in the same manner as with the resist of Example 1 to determine a sensitivity set forth in prioir literature, i.e. an exposure capable of delineating 1 $\mu$ m L/S, with the result that the exposure was found to be 70 mJ/cm$^2$ (1.8 counts). From this, it was found that the photosensitive resin of the invention was highly sensitive.

(II) Exposure with a KrF Excimer Laser

The patterning procedure as set forth above was repeated except that the photosensitive resin of Example 1 was used and a light source for the exposure was a KrF Excimer Laser, thereby determining sensitivity and a minimum resolution size where the KrF Excimer Laser was used. The laser oscillator used was one available from Lambda Physics Co., Ltd. This laser oscillator can yield an irradiation of 4.8 mJ/cm$^2$ per pulse and can control an exposure depending on the number of pulses.

As a result, the sensitivity ($D_n^{0.5}$) was found to be 350 mJ/cm$^2$. The minimum resolution size was 0.5 $\mu$ m lines and spaces.

Results on a resistance to $O_2$-RIE

The sample obtained by the above pattering test using the KrF Excimer Laser was set in a DEM 451 parallel flat plate dry etcher (available from Nichiden Annerba K.K.) and subjected to pattering of the undercoating layer (MP 2400). More particularly, the undercoating layer was patternized through a mask of the pattern of the photosensitive resin of Example 1. The dry etching was effected under conditions of an $O_2$ gas pressure of 1.0 Pa, an $O_2$ gas flow rate of 20 SCCM, a RF power density of 0.12 W/cm$^2$ and an etching time of 35 minutes.

The resultant two-layered resist pattern was observed in section through SEM, revealing that a 0.5 $\mu$ m line and space pattern was formed at an aspect ratio of 3.4 in the form of a rectangle.

The etcing speed of the photosensitive resin was found to be 4.17 nm/minute. It should be noted that in view of the fact that the etching speed of a typical known photosensitive resin is 15 nm/minute under milder etching conditions, the photosensitive resin of the invention has a better $O_2$-RIE resistance than the known resin.

## Claims

1. A photosensitive resin which comprises a poly(siloxane) derivative comprising siloxane units having at least one group selected from the group consisting of an unsaturated group, an alkyl group and a halogenated allyl group and terminated with a polysilanyl end group.

2. A photosensitive resin according to Claim 1, wherein said resin consists essentially of said poly(siloxane) derivative.

3. A photosensitive resin according to Claim 1, wherein said at least one member is an unsaturated group selected from the group consisting of a vinyl group, an allyl group, an isopropenyl group and a 2-butenyl group.

4. A photosensitive resin according to Claim 1, wherein said at least one member is an alkyl group selected from the group consisting of a methyl group, an ethyl grop, an n-propyl group, an iso-propyl group, an n-butyl group, an iso-butyl group and a tert-butyl group.

5. A photosensitive resin according to Claim 1, wherein said at least one member is a halogenated alkyl group selected from the group consisting of a chloromethyl group, a chloroethyl group, a chloropropyl group, a chlorobutyl group, a bromomethyl group, a bromoethyl group, a bromopropyl group, a bromobutyl group, an iodomethyl group, an iodoethyl group, an iodopropyl group and an iodobutyl group.

6. A photosensitive resin according to Claim 1, wherein said polysilanyl end group is of the following formula

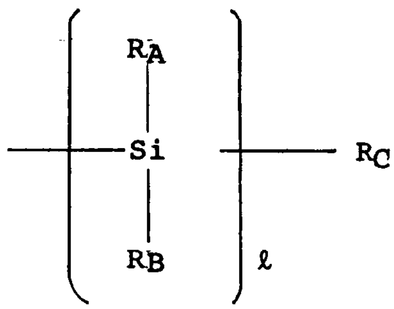

wherein $R_A$ and $R_B$ are, respectively, a group selected from the group consisting of the following groups (a) to (e)

(a) a linear, branched or cyclic alkyl group having not larger than 10 carbon atoms,
(b) an unsubstituted phenyl group,
(c) an unsubstituted naphthyl group,
(d) a phenyl group having one group selected from the group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom, $R_C$ is a group selected from the group consisting of the following groups (f) to (k)
(f) an alkyl group having not larger than 10 carbon atoms,
(g) an unsubstituted phenyl group,
(h) an unsubstituted naphthyl group,
(i) a phenyl group having one group selected from the group consisting of a nitro group, an alkoxy group, and a halogen atom, and
(j) a naphthyl group having one group selected from the group consisting of a nitro group, an alkoxy group, and a halogen atom, and
(k) an alkoxy group having not larger than 5 carbon atoms, and $\ell$ is such integer that $2 \leqq \ell \leqq 10$.

7. A photosensitive resin according to Claim 1, wherein said polysilanyl end group is of the following formula

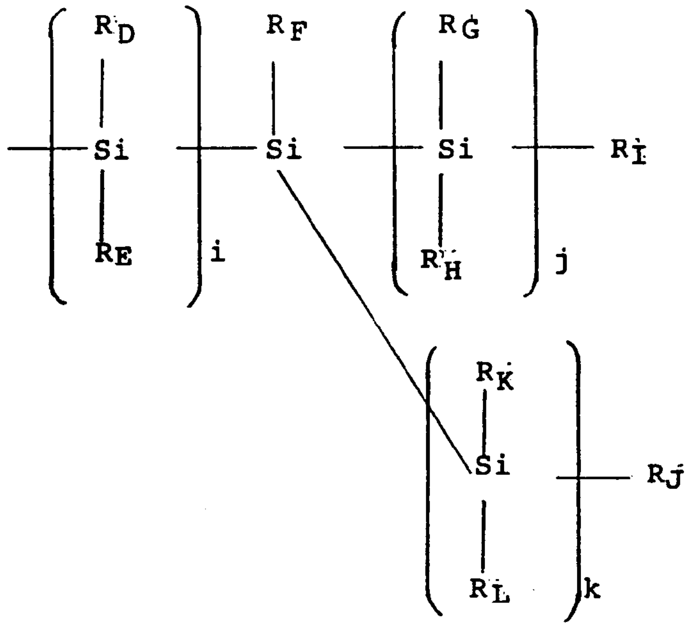

wherein $R_D$, $R_E$, $R_F$, $R_G$, $R_H$, $R_K$ and $R_L$ are, respectively, a group selected from the group consisting of the following groups ( a ) to ( e )

(a) a linear, branched or cyclic alkyl group having not larger than 10 carbon atoms,

(b) an unsubstituted phenyl group,

(c) an unsubstituted naphthyl group,

(d) a phenyl group having one group selected from the group consisting of a nitro group, an alkoxy group having not larger than 5 carbon atoms, and a halogen atom, and

(e) a naphthyl group having one group selected from the group consisting of a nitro group, an alkoxy group having not larger than 5 carbon atoms, and a halogen atom, $R_I$ and $R_J$ are, respectively, a group selected from the group consisting of the following groups (f) to (k)

(f) an alkyl group having not larger than 10 carbon atoms,

(g) an unsubstituted phenyl group,

(h) an unsubstituted naphthyl group,

(i) a phenyl group having one group selected from the group consisting of a nitro group, an alkoxy group, and a halogen atom,

(j) a naphthyl group having one group selected from the group consisting of a nitro group, an alkoxy group, and a halogen atom, and

(k) an alkoxy group having not larger than 5 carbon atoms, and i, j, and k are such integers that $0 \leqq i \leqq 7$, $1 \leqq j \leqq 8$, $1 \leqq k \leqq 8$ and $i + j + k \leqq 9$.

**8.** A photosensitive resin according to Claim 1, wherein said poly(siloxane) derivative is obtained from a linear, hydroxyl-terminated poly(siloxane) derivative having a weight average molecular weight of from 2,000 to 100,000.

**9.** A photosensitive resin according to Claim 1, wherein said poly(siloxane) derivative is obtained from a hydroxyl-terminated polysilsesquioxane derivative having a weight average molecular weight of from 2,000 to 100,000.

**10.** A photosensitive resin according to Claim 1, wherein said poly(siloxane) derivative is of the following general formula

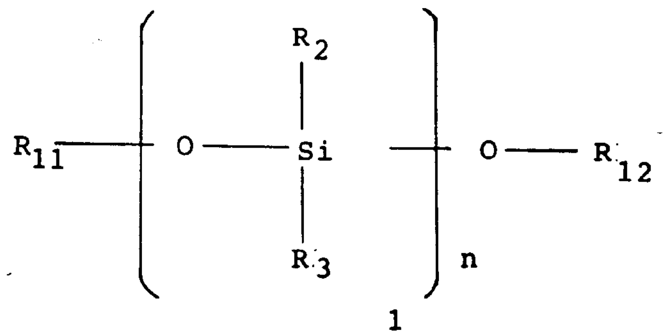

wherein $R_{11}$ and $R_{12}$ are, respectively, a polysilanyl group, $R_2$ and $R_3$ are, respectively, a member selected from the group consisting of an unsaturated group, an alkyl group and a halogenated alkyl group, n is a positive integer.

**11.** A photosensitive resin according to Claim 10, wherein said at least one member is an unsaturated group selected from the group consisting of a vinyl group, an allyl group, an isopropenyl group and a 2-butenyl group.

**12.** A photosensitive resin according to Claim 10, wherein said at least one member is an alkyl group selected from the group consisting of a methyl group, and an ethyl group, an n-propyl group, an iso-propyl group, an n-butyl group, an iso-butyl group and a tert-butyl group.

**13.** A photosensitive resin according to Claim 11, wherein said at least one member is a halogeneted alkyl group selected from the group consisting of a chloromethyl group, a chloroethyl group, a chloropropyl group, a chlorobutyl group, a bromomethyl group, a bromoethyl group, a bromopropyl group, a bromobutyl group, an iodomethyl group, an iodoethyl group, an iodopropyl group and an iodobutyl group.

**14.** A photosensitive resin according to Claim 11, wherein said polysilanyl end group is of the following formula

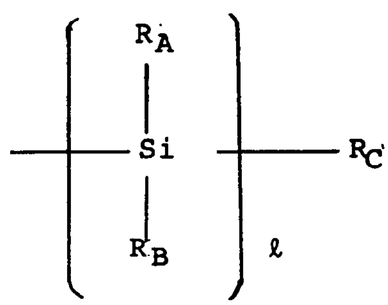

wherein $R_A$ and $R_B$ are respectively a group selected from the group consisting of the following groups (a) to (e)

(a) a linear, branched or cyclic alkyl group having not larger than 10 carbon atoms,
(b) an unsubstituted phenyl group,
(c) an unsubstituted naphthyl group,
(d) a phenyl group having one group selected from the group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom, $R_C$ is a group selected from the group consisting of the following groups (f) to (k)
(f) an alkyl group having not larger than 10 carbon atoms,
(g) an unsubstituted phenyl group,
(h) an unsubstituted naphthyl group,
(i) a phenyl group having one group selected from the group consisting of a nitro group, an alkoxy group, and a halogen atom, and

(j) a naphthyl group having one group selected from the group consisting of a nitro group, an alkoxy group, and a halogen atom, and
(k) an alkoxy group having not larger than 5 carbon atoms, and $\ell$ is such an integer that $2 \leqq \ell \leqq 10$.

**15.** A photosensitive resin according to Claim 11, wherein said polysilanyl end group is of the following formula

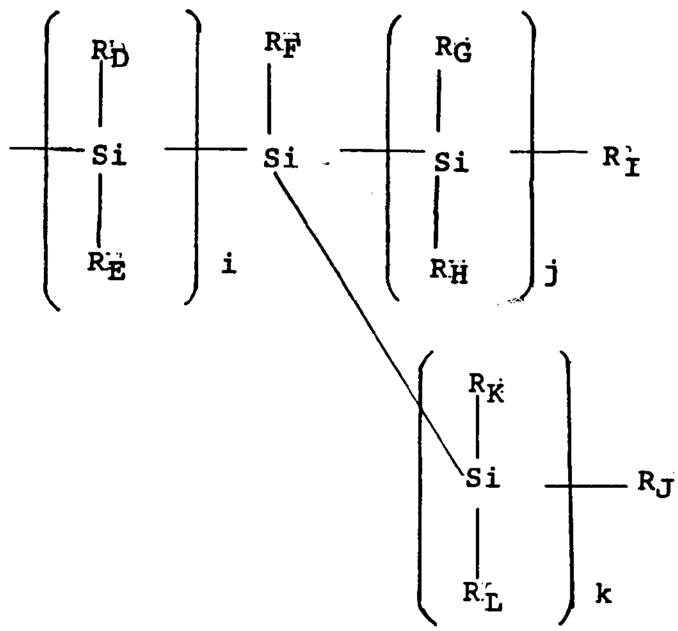

wherein $R_D$, $R_E$, $R_F$, $R_G$, $R_H$, $R_K$ and $R_L$ are, respectively, a group selected from the group consisting of the following groups (a) to (e)
(a) a linear, branched or cyclic alkyl group having not larger than 10 carbon atoms,
(b) an unsubstituted phenyl group,
(c) an unsubstituted naphthyl group,
(d) a phenyl group having one group selected from hte group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom, $R_I$ and $R_J$ are, respectively, a group selected from the group consisting of the following groups (f) to (k)
(f) an alkyl group having not larger than 10 carbon atoms,
(g) an unsubstituted phenyl group,
(h) an unsubstituted naphthyl group,
(i) a phenyl group having one group selected from the group consisting of a nitro group, an alkoxy group, and a halogen atom, and
(j) a naphthyl group having one group selected from the group consisting of a nitro group, an alkoxy group, and a halogen atom, and
(k) an alkoxy group having not larger than 5 carbon atoms, and i, j and k are such integers that $0 \leqq i \leqq 7$, $1 \leqq j \leqq 8$, $1 \leqq k \leqq 8$ and $i + j + k \leqq 9$.

**16.** A photosensitive resin according to Claim 11, wherein said poly(siloxane) derivative is obtained from a linear, hydroxyl-terminated poly(siloxane) derivative having a weight average molecular weight of from 2,000 to 100,000.

**17.** A photosensitive resin according to Claim 1, wherein said poly(siloxane) derivative is of the following formula

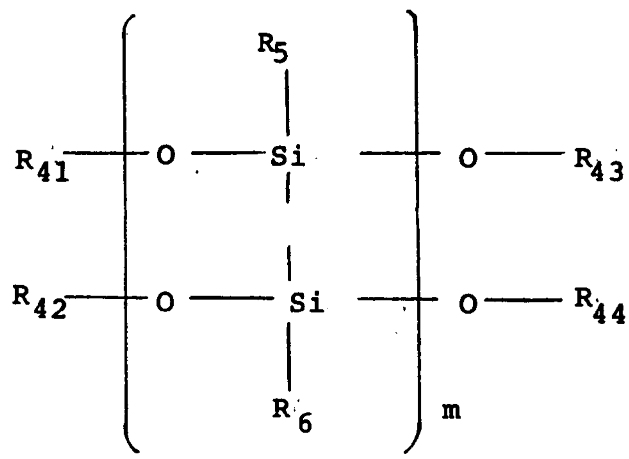

wherein $R_{41}$, $R_{42}$, $R_{43}$ and $R_{44}$ are, respectively, a polysilanyl group, $R_5$ and $R_6$ are, respectively, a member selected from the group consisting of an unsaturated group, an alkyl group and a halogenated group, and m is a positive integer.

**18.** A photosensitive resin according to Claim 17, wherein said at least one member is an unsaturated group selected from the group consisting of a vinyl group, an allyl group, an isopropenyl group and a 2-butenyl group.

**19.** A photosensitive resin according to Claim 17, wherein said at least one member is an alkyl group selected from the group consisting of a methyl group, an ethyl group, an n-propyl group, an iso-propyl group, an n-butyl group, an iso-butyl group and a tert-butyl group.

**20.** A photosensitive resin according to Claim 17, wherein said at least one member is a halogenated alkyl group selected from the group consisting of a chloromethyl group, a chloroethyl group, a chloropropyl group, a chlorobutyl group, a bromomethyl group, a bromoethyl group, a bromopropyl group, a bromobutyl group, an iodomethyl group, an iodoethyl group, an iodopropyl group and an iodobutyl group.

**21.** A photosensitive resin according to Claim 17, wherein said polysilanyl end group is of the following formula

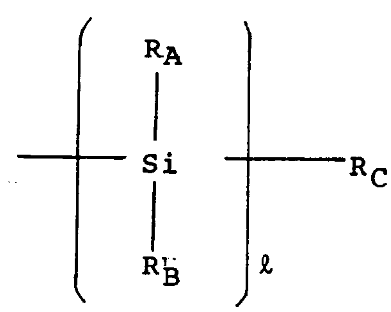

wherein $R_A$ and $R_B$ are, respectively, a group selected from the group consisting of the following groups (a) to (e)

(a) a linear, branched or cyclic alkyl group having not larger than 10 carbon atoms,
(b) an unsubstituted phenyl group,
(c) an unsubstituted naphthyl group,
(d) a phenyl group having one group selected from the group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom, $R_C$ is a group selected from the group consisting of the following groups (f) to (k)
(f) an alkyl group having not larger than 10 carbon atoms,
(g) an unsubstituted phenyl group,

(h) an unsubstituted naphthyl group,
(i) a phenyl group having one group selected from the group consisting of a nitro group, an alkoxy group, and a halogen atom, and
(j) a naphtyl group having one group selected from the group consisting of a nitro group, an alkoxy group, and a halogen atom, and
(k) an alkoxy group having not larger than 5 carbon atoms, and $\ell$ is such an integer that $2 \leqq \ell \leqq 10$.

**22.** A photosensitive resin according to claim 17, wherein said polysilanyl end group is of the following formula

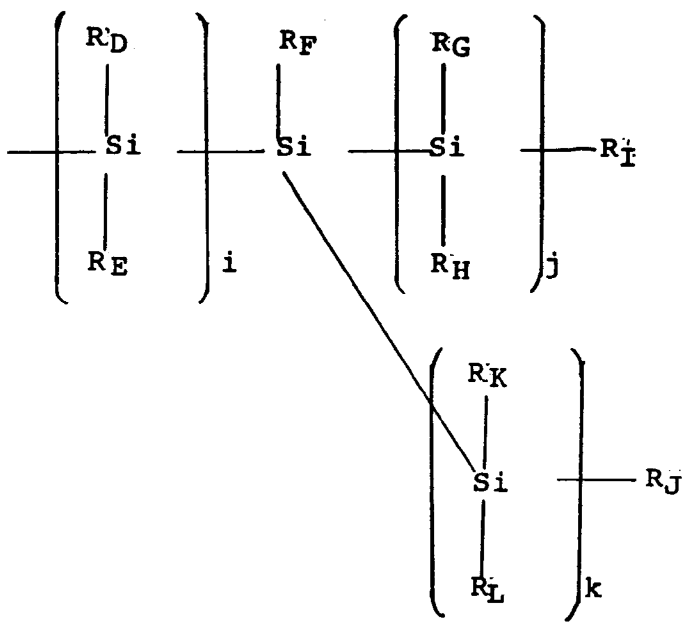

wherein $R_D$, $R_E$, $R_F$, $R_G$, $R_H$, $R_K$ and $R_L$ are, respectively, a group selected from the group consisting of the following groups (a) to (e)
(a) a linear, branched or cyclic alkyl group having not larger than 10 carbon atoms,
(b) an unsubstituted phenyl group,
(c) an unsubstituted naphthyl group,
(d) a phenyl group having one group selected from the group consisting of a nitro group, an alkoxy group having not larger than 5 carbon atoms, and a halogen atom, and
(e) a naphthyl group having one group selected from the group consisting of a nitro group, an alkoxy group having not larger than 5 carbon atoms, and a halogen atom, $R_I$ and $R_J$ are, respectively, a group selected from the group consisting of the following groups (f) to (k)
(f) an alkyl group having not larger than 10 carbon atoms,
(g) an unsubstituted phenyl group,
(h) an unsubstituted naphthyl group,
(i) a phenyl group having one group selected from the group consisting of a nitro group, an alkoxy group, and a halogen atom, and
(j) a naphthyl group having one group selected from the group consisting of a nitro group, an alkoxy group, and a halogen atom, and
(k) an alkoxy group having not larger than 5 carbon atoms, and i, j and k are such integers that $0 \leqq i \leqq 7$, $1 \leqq j \leqq 8$, $1 \leqq k \leqq 8$ and $i + j + k \leqq 9$.

**23.** A photosensitive resin according to Claim 17, wherein said poly(siloxane) derivative is obtained from a hydroxyl-terminated polysilsesquioxane derivative having a weight average molecular weight of from 2,000 to 100,000.

## Patentansprüche

**1.** Lichtempfindliches Harz, das umfaßt ein Poly(siloxan)derivat, enthaltend Siloxan-Einheiten, die mindestens eine Gruppe, ausgewählt aus der Gruppe, die besteht aus einer ungesättigten Gruppe, einer Alkylgruppe und einer halogenierten Alkylgruppe, aufweisen und mit einer Polysilanyl-Endgruppe abgeschlossen sind.

2. Lichtempfindliches Harz nach Anspruch 1, worin das genannte Harz im wesentlichen aus dem genannten Poly(siloxan)derivat besteht.

3. Lichtempfindliches Harz nach Anspruch 1, worin der mindestens eine Vertreter eine ungesättigte Gruppe, ausgewählt aus der Gruppe, die besteht aus einer Vinylgruppe, einer Allylgruppe, einer Isopropenylgruppe und einer 2-Butenylgruppe, ist.

4. Lichtempfindliches Harz nach Anspruch 1, worin der mindestens eine Vertreter eine Alkylgruppe, ausgewählt aus der Gruppe, die besteht aus einer Methylgruppe, einer Ethylgruppe, einer n-Propylgruppe, einer Isopropylgruppe, einer n-Butylgruppe, einer Isobutylgruppe und einer tert-Butylgruppe, ist.

5. Lichtempfindliches Harz nach Anspruch 1, worin der mindestens eine Vertreter eine halogenierte Alkylgruppe, ausgewählt aus der Gruppe, die besteht aus einer Chloromethylgruppe, einer Chloroethylgruppe, einer Chloropropylgruppe, einer Chlorobutylgruppe, einer Bromomethylgruppe, einer Bromoethylgruppe, einer Bromopropylgruppe, einer Bromobutylgruppe, einer Jodomethylgruppe, einer Jodoethylgruppe, einer Jodopropylgruppe und einer Jodobutylgruppe, ist.

6. Lichtempfindliches Harz nach Anspruch 1, worin die genannte Polysilanyl-Endgruppe eine solche der folgenden Formel ist

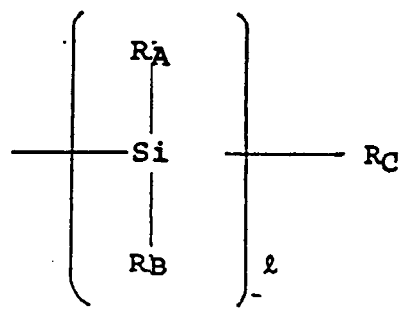

worin $R_A$ und $R_B$ jeweils stehen für eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom;

worin $R_C$ steht für eine Gruppe, ausgewählt aus der Gruppe, die besteht aus den folgenden Gruppen (f) bis (k):

f) einer Alkylgruppe mit nicht mehr als 10 Kohlenstoffatomen,
g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

$l$ steht für eine solche ganze Zahl, daß $2 \leqq l \leqq 10$.

7. Lichtempfindliches Harz nach Anspruch 1, worin die genannte Polysilanyl-Endgruppe eine solche der folgenden Formel ist

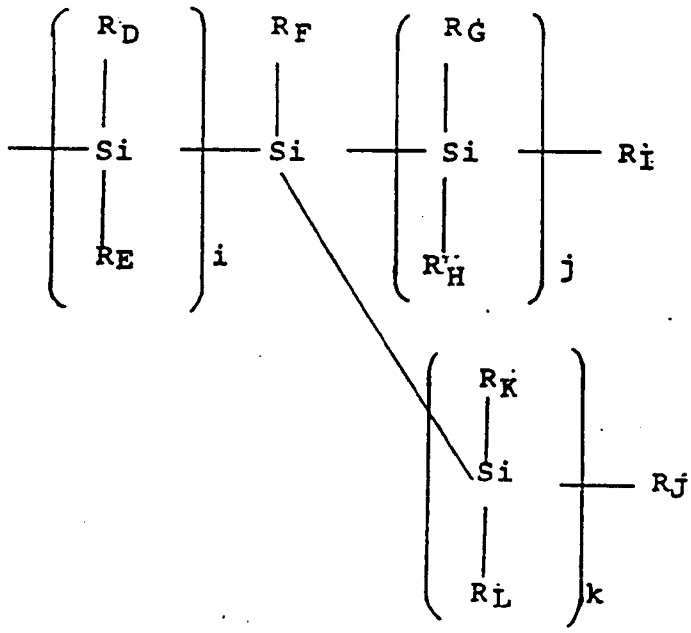

worin bedeuten:

$R_D$, $R_E$, $R_F$, $R_G$, $R_H$, $R_K$ und $R_L$ jeweils eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom;

$R_I$ und $R_J$ jeweils eine Gruppe, ausgewählt aus der Gruppe, die besteht aus den folgenden Gruppen (f) bis (k)

f) einer Alkylgruppe mit nicht mehr als 10 Kohlenstoffatomen,
g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

i, j und k solche ganze Zahlen, daß $0 \leqq i \leqq 7$; $1 \leqq j \leqq 8$; $1 \leqq k \leqq 8$ und $i + j + k \leqq 9$.

**8.** Lichtempfindliches Harz nach Anspruch 1, worin das genannte Poly(siloxan)derivat erhalten wird aus einem linearen, Hydroxyl-terminierten Poly(siloxan)derivat mit einem gewichtsdurchschnittlichen Molekulargewicht von 2000 bis 100 000.

**9.** Lichtempfindliches Harz nach Anspruch 1, worin das genannte Poly(siloxan)derivat erhalten wird aus einem Hydroxyl-terminierten Polysilsesquioxanderivat mit einem gewichtsdurchschnittlichen Molekulargewicht von 2000 bis 100 000.

**10.** Lichtempfindliches Harz nach Anspruch 1, worin das genannte Poly(siloxan)derivat ein solches der folgenden allgemeinen Formel ist

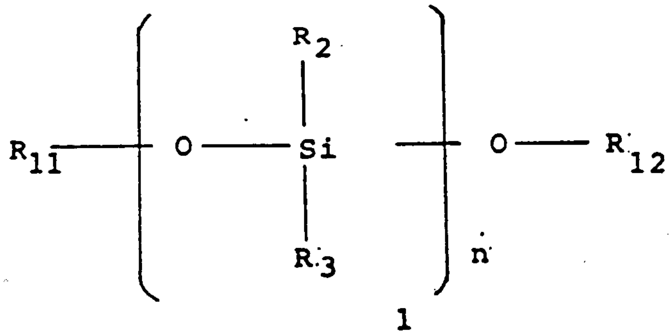

1

worin bedeuten:

$R_{11}$ und $R_{12}$ jeweils eine Polysilanylgruppe,

$R_2$ und $R_3$ jeweils einen Vertreter, ausgewählt aus der Gruppe, die besteht aus einer ungesättigten Gruppe, einer Alkylgruppe und einer halogenierten Alkylgruppe, und

n eine positive ganze Zahl.

**11.** Lichtempfindliches Harz nach Anspruch 10, worin dieser mindestens eine Vertreter eine ungesättigte Gruppe, ausgewählt aus der Gruppe, die besteht aus einer Vinylgruppe, einer Allylgruppe, einer Isopropenylgruppe und einer 2-Butenylgruppe, ist.

**12.** Lichtempfindliches Harz nach Anspruch 10, worin dieser mindestens eine Vertreter einer Alkylgruppe, ausgewählt aus der Gruppe, die besteht aus einer Methylgruppe und einer Ethylgruppe, einer n-Propylgruppe, einer Isopropylgruppe, einer n-Butylgruppe, einer Isobutylgruppe und einer tert-Butylgruppe, ist.

**13.** Lichtempfindliches Harz nach Anspruch 11, worin dieser mindestens eine Vertreter eine halogenierte Alkylgruppe, ausgewählt aus der Gruppe, die besteht aus einer Chloromethylgruppe, einer Chloroethylgruppe, einer Chloropropylgruppe, einer Chlorobutylgruppe, einer Bromomethylgruppe, einer Bromoethylgruppe, einer Bromopropylgruppe, einer Bromobutylgruppe, einer Jodomethylgruppe, einer Jodoethylgruppe, einer Jodopropylgruppe und einer Jodobutylgruppe, ist.

**14.** Lichtempfindliches Harz nach Anspruch 11, worin die genannte Polysilanylendgruppe eine solche der folgenden Formel ist

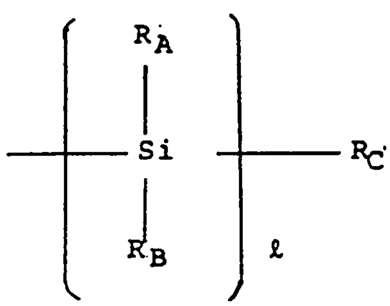

worin bedeuten:

$R_A$ und $R_B$ jeweils eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom,

$R_C$ eine Gruppe, ausgewählt aus der Gruppe, die besteht aus den folgenden Gruppen (f) bis (k):

f) einer Alkylgruppe mit nicht mehr als 10 Kohlenstoffatomen,
g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

l eine solche ganze Zahl, daß $2 \leqq l \leqq 10$.

**15.** Lichtempfindliches Harz nach Anspruch 11, worin die genannte Polysilanylendgruppe eine solche der folgenden Formel ist

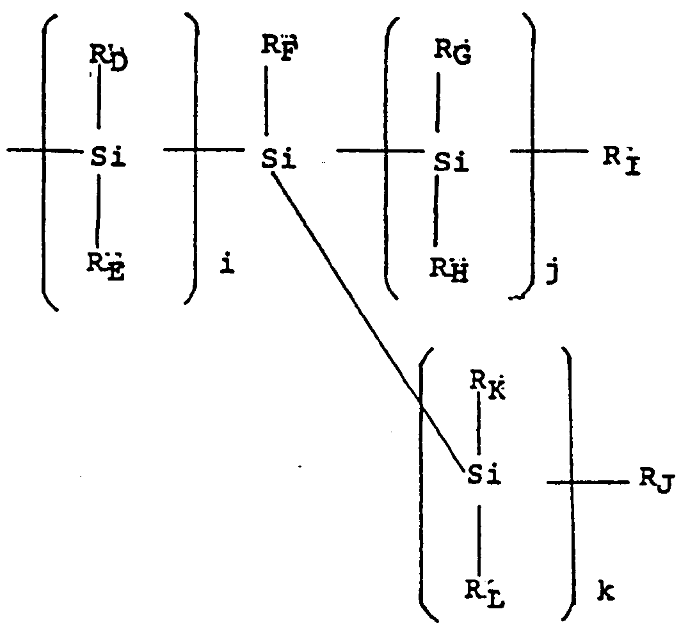

worin bedeuten:

$R_D$, $R_E$, $R_F$, $R_G$, $R_H$, $R_K$ und $R_L$ jeweils eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom;

$R_I$ und $R_J$ jeweils eine Gruppe, ausgewählt aus der Gruppe, die besteht aus den folgenden Gruppen (f) bis (k)

f) einer Alkylgruppe mit nicht mehr als 10 Kohlenstoffatomen,
g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

i, j und k solche ganze Zahlen, daß $0 \leqq i \leqq 7$; $1 \leqq j \leqq 8$; $1 \leqq k \leqq 8$ und $i + j + k \leqq 9$.

**16.** Lichtempfindliches Harz nach Anspruch 11, worin das genannte Poly(siloxan)derivat erhalten wird aus

einem linearen, Hydroxyl-terminierten Poly(siloxan)derivat mit einem gewichtsdurchschnittlichen Molekulargewicht von 2000 bis 100 000.

17. Lichtempfindliches Harz nach Anspruch 1, worin das genannte Poly(siloxan)derivat ein solches des folgenden Formel ist

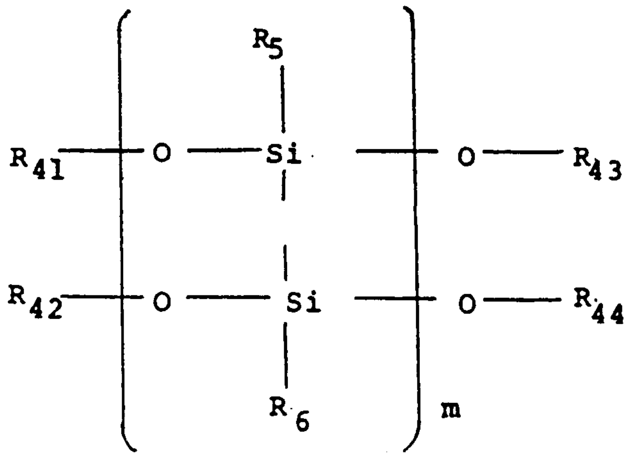

worin bedeuten:

| | |
|---|---|
| $R_{41}$, $R_{42}$, $R_{43}$ und $R_{44}$ | jeweils eine Polysilanylgruppe, |
| $R_5$ und $R_6$ | jeweils einen Vertreter, ausgewählt aus der Gruppe, die besteht aus einer ungesättigten Gruppe, einer Alkylgruppe und einer halogenierten Alkylgruppe und |
| m | eine positive ganze Zahl. |

18. Lichtempfindliches Harz nach Anspruch 17, worin dieser mindestens eine Vertreter eine ungesättigte Gruppe, ausgewählt aus der Gruppe, die besteht aus einer Vinylgruppe, einer Allylgruppe, einer Isopropenylgruppe und einer 2-Butenylgruppe, ist.

19. Lichtempfindliches Harz nach Anspruch 17, worin dieser mindestens eine Vertreter eine Alkylgruppe, ausgewählt aus der Gruppe, die besteht aus einer Methylgruppe, einer Ethylgruppe, einer n-Propylgruppe, einer Isopropylgruppe, einer n-Butylgruppe, einer Isobutylgruppe und einer tert-Butylgruppe, ist.

20. Lichtempfindliches Harz nach Anspruch 17, worin dieser mindestens eine Vertreter eine halogenierte Alkylgruppe, ausgewählt aus der Gruppe, die besteht aus einer Chloromethylgruppe, einer Chloroethylgruppe, einer Chloropropylgruppe, einer Chlorobutylgruppe, einer Bromomethylgruppe, einer Bromoethylgruppe, einer Bromopropylgruppe, einer Bromobutylgruppe, einer Jodomethylgruppe, einer Jodoethylgruppe, einer Jodopropylgruppe und einer Jodobutylgruppe, ist.

21. Lichtempfindliches Harz nach Anspruch 17, worin die genannte Polysilanylendgruppe eine solche der folgenden Formel ist

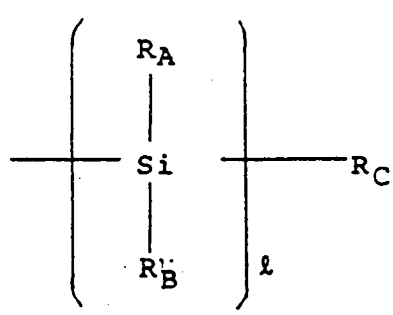

worin bedeuten:

$R_A$ und $R_B$ jeweils eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom,

$R_C$ eine Gruppe, ausgewählt aus der Gruppe, die besteht aus den folgenden Gruppen (f) bis (k):

f) einer Alkylgruppe mit nicht mehr als 10 Kohlenstoffatomen,
g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

$l$ eine solche ganze Zahl, daß $2 \leqq l \leqq 10$.

**22.** Lichtempfindliches Harz nach Anspruch 17, worin die genannte Polysilanylendgruppe eine solche der folgenden Formel ist

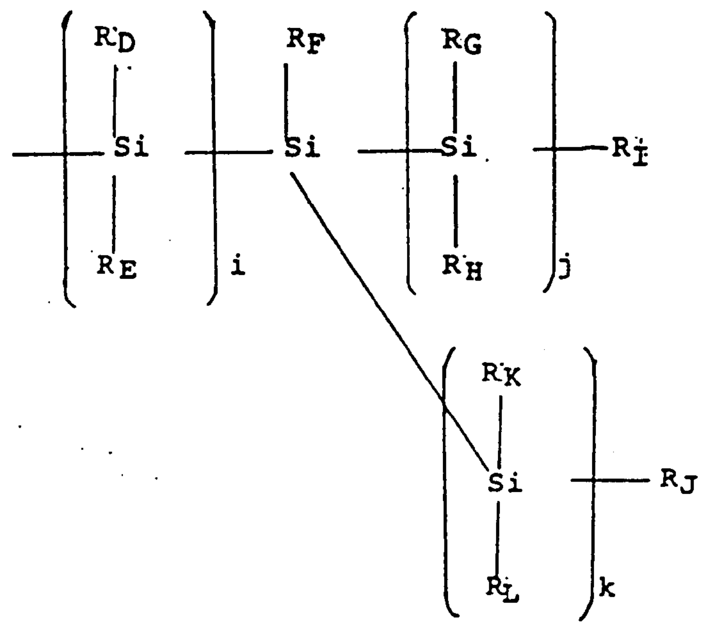

worin bedeuten:

$R_D$, $R_E$, $R_F$, $R_G$, $R_H$, $R_K$ und $R_L$ jeweils eine Gruppe, ausgewählt aus der Gruppe, die besteht aus den folgenden Gruppen (a) bis (e):

a) einer linearen, verzweigten oder cyclischen Alkylgruppe mit nicht mehr als 10 Kohlenstoffatomen,
b) einer unsubstituierten Phenylgruppe,
c) einer unsubstituierten Naphthylgruppe,
d) einer Phenylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom, und
e) einer Naphthylgruppe, die eine Gruppe aufweist, ausgewählt aus der Gruppe, die besteht aus einer Nitrogruppe, einer Alkoxygruppe mit nicht mehr als 5 Kohlenstoffatomen und einem Halogenatom;

$R_I$ und $R_J$ jeweils eine Gruppe, ausgewählt aus der Gruppe, die besteht aus den folgenden Gruppen (f) bis (k)

f) einer Alkylgruppe mit nicht mehr als 10 Kohlenstoffatomen,

g) einer unsubstituierten Phenylgruppe,
h) einer unsubstituierten Naphthylgruppe,
i) einer Phenylgruppe, die eine Gruppe aufweist, ausgewählt aus der Gruppe, die besteht aus einer Nitrogruppe, einer Alkoxygruppe und einem Halogenatom,
j) einer Naphthylgruppe, die eine Gruppe aufweist, ausgewählt aus der Gruppe, die besteht aus einer Nitrogruppe, einer Alkoxygruppe und einem Halogenatom, und
k) einer Alkoxygruppe mit nicht mehr als 5 Kohlenstoffatomen, und

i, j und k solche ganze Zahlen, daß $0 \leqq i \leqq 7$; $1 \leqq j \leqq 8$; $1 \leqq k \leqq 8$ und $i + j + k \leqq 9$.

23. Lichtempfindliches Harz nach Anspruch 17, worin das genannte Poly(siloxan)derivat erhalten wird aus einem Hydroxyl-terminierten Polysilsesquioxanderivat mit einem gewichtsdurchschnittlichen Molekulargewicht von 2000 bis 100 000.

## Revendications

1. Résine photosensible qui comporte un dérivé de poly(siloxane) comportant des unités de siloxane ayant au minimum un groupe sélectionné à partir du groupe consistant d'un groupe non-saturé, un groupe alcoyle et un groupe allyle halogéné et terminant avec un groupe terminal polysilanyle.

2. Résine photosensible selon la revendication 1, dont ladite résine consiste essentiellement dudit dérivé de poly(siloxane).

3. Résine photosensible selon la revendication 1, dont un membre au minimum est un groupe non-saturé sélectionné à partir du groupe consistant d'un groupe vinyle, d'un groupe allyle, d'un groupe iso-propényle et d'un groupe 2-buténylе.

4. Résine photosensible selon la revendication 1, dont un membre au minimum est un groupe alcoyle sélectionné à partir du groupe consistant d'un groupe méthyle, d'un groupe éthyle, d'un groupe n-propyle, d'un groupe isopropyle, d'un groupe n-butyle, d'un groupe isobutyle et d'un groupe tert-butyle.

5. Résine photosensible selon la revendication 1, dont un membre au minimum est un groupe alcoyle halogéné sélectionné à partir du groupe consistant d'un groupe chlorométhyle, d'un groupe chloroéthyle, d'un groupe chloropropyle, d'un groupe chlorobutyle, d'un groupe bromométhyle, d'un groupe bromoéthyle, d'un groupe bromopropyle, d'un groupe bromobutyle, d'un groupe iodométhyle, d'un groupe iodo-éthyle, d'un groupe iodopropyle et d'un groupe iodobutyle.

6. Résine photosensible selon la revendication 1, dont ledit groupe terminal polysilanyle est de formule suivante

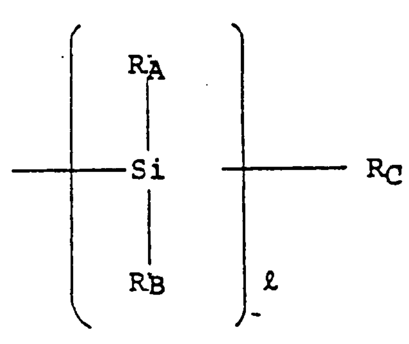

dont $R_A$ et $R_B$ respectivement sont un groupe sélectionné à partir du groupe consistant des groupes suivants (a) à (e)

(a) un groupe alcoyle linéaire, ramifié ou cyclique ayant un maximum de 10 atomes de carbone,
(b) un groupe phényle non-substitué,
(c) un groupe naphthyle non-substitué,

(d) un groupe phényle comportant un groupe sélectionné à partir du groupe consistant d'un groupe nitro, un groupe alkoxy avec un maximum de 5 atomes de carbone, et un atome halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_C$ est un groupe sélectionné à partir du groupe consistant des groupes suivants (f) à (k)
(f) un groupe alcoyle ayant un maximum de 10 atomes de carbone,
(g) un groupe phényle non-substitué,
(h) un groupe naphthyle non-substitué,
(i) un groupe phényle comportant un groupe sélectionné à partir du groupe consistant d'un groupe nitro, un groupe alkoxy, et d'un atome halogène, et
(j) un groupe naphthyle comportant un groupe sélectionné à partir du groupe consistant d'un groupe nitro, un groupe alkoxy, et d'un atome halogène, et
(k) un groupe alkoxy comportant un groupe ayant un maximum de 5 atomes de carbone, et $\ell$ est un nombre entier tel que $2 \leqq \ell \leqq 10$.

7. Résine photosensible selon la revendication 1, dont ledit groupe terminal polysinanyle est de formule suivante

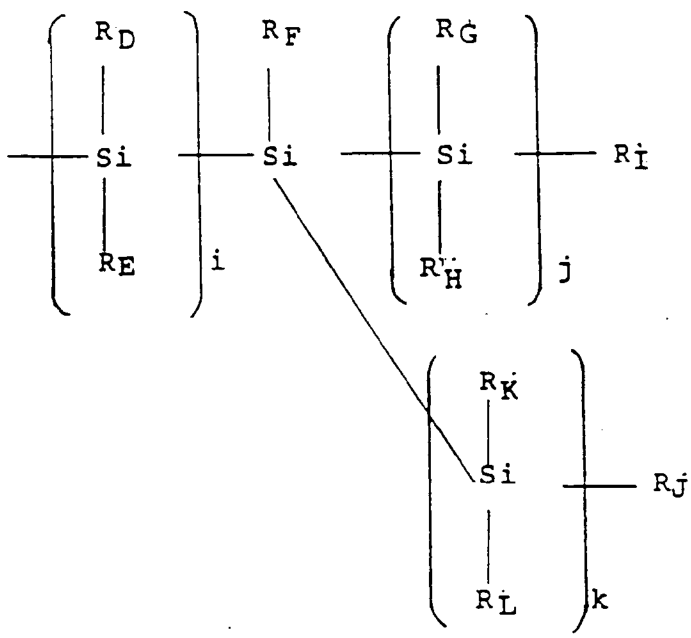

selon laquelle $R_D$, $R_E$, $R_F$, $R_G$, $R_H$, $R_K$ et $R_L$ respectivement sont un groupe sélectionné à partir du groupe consistant des groupes suivants (a) à (e)
(a) un groupe alcoyle linéaire, ramifié ou cyclique comportant un maximum de 10 atomes de carbone,
(b) un groupe phényle non-substitué,
(c) un groupe naphthyle non-substitué,
(d) un groupe phényle avec un groupe sélectionné à partir du groupe consistant d'un groupe nitro, d'un groupe alkoxy ayant un maximum de 5 atomes de carbone, et un atome halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_I$ et $R_J$ respectivement sont un groupe consistant des groupes suivants (f) à (k)
(f) un groupe alcoyle avec un maximum de 10 atomes de carbone,
(g) un groupe phényle non-substitué,
(h) un groupe naphthyle non-substitué,
(i) un groupe phényle ayant un groupe sélectionné à partir du groupe consistant d'un groupe nitro, un groupe alkoxy, et d'un atome halogène,
(j) un groupe naphthyle ayant un groupe sélectionné à partir du groupe consistant d'un groupe nitro, un groupe alkoxy, et d'un atome halogène, et
(k) un groupe alkoxy ayant un maximum de 5 atomes de carbone, et dont i, j, et k représentent une

série de nombres entiers de façon telle que $0 \leqq i \leqq 7$, $1 \leqq j \leqq 8$, $1 \leqq k \leqq 8$ et $i + j + k \leqq 9$.

**8.** Résine photosensible selon la revendication 1, dont ledit dérivé poly(siloxane) est obtenu à partir d'un dérivé linéaire poly(siloxane) à terminaison hydroxyle de poids moléculaire moyen de l'ordre de 2 000 à 100 000.

**9.** Résine photosensible selon la revendication 1, dont ledit dérivé poly(siloxane) est obtenu à partir d'un dérivé polysilsesquixoane à terminaison hydroxyle de poids moléculaire moyen de l'ordre de 2 000 à 100 000.

**10.** Résine photosensible selon la revendication 1, dont ledit dérivé poly(siloxane) prévoit la formule générale suivante

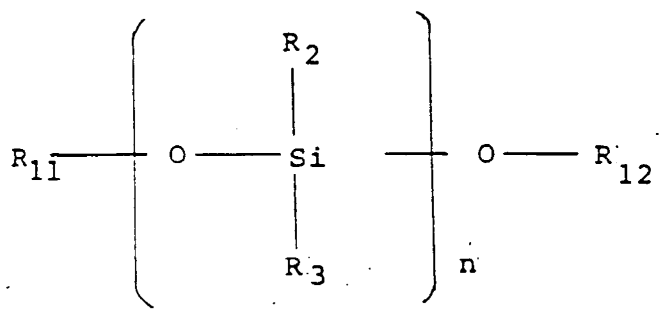

1

dont $R_{11}$ et $R_{12}$ sont respectivement un groupe polysilanyle, $R_2$ et $R_3$ sont respectivement un membre sélectionné à partir du groupe comportant un groupe non saturé, un groupe alcoyle et un groupe alcoyle halogéné, n étant un nombre entier positif.

**11.** Résine photosensible selon la revendication 10, dont un membre au minimum est un groupe non-saturé sélectionné à partir du groupe comportant un groupe vinyle, un groupe allyle, un groupe isopropényle et un groupe 2-butényle.

**12.** Résine photosensible selon la revendication 10, dont un membre au minimum est un groupe alcoyle sélectionné à partir du groupe consistant d'un groupe méthyle, un groupe éthyle, un groupe n-propyle, un groupe isopropyle, un groupe n-butyle, un groupe isobutyle et un groupe tert-butyle.

**13.** Résine photosensible selon la revendication 11, dont un membre au minimum est un groupe alcoyle halogéné sélectionné à partir du groupe consistant d'un groupe chlorométhyle, un groupe chloroéthyle, un groupe chloropropyle, un groupe chlorobutyle, un groupe bromo-méthyle, un groupe bromoéthyle, un groupe bromopropyle, un groupe bromo-butyle, un groupe iodométhyle, un groupe iodoéthyle, un groupe iodopropyle et un groupe iodobutyle.

**14.** Résine photosensible selon la revendication 11, dont ledit groupe terminal polysilanyle est de formule suivante

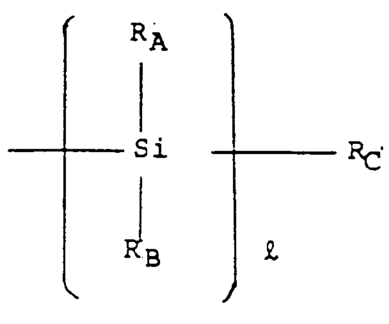

dont $R_A$ et $R_B$ respectivement sont un groupe sélectionné à partir du groupe consistant des groupes suivants (a) à (e)

(a) un groupe alcoyle linéaire, ramifié ou cyclique ayant un maximum de 10 atomes de carbone,
(b) un groupe phényle non-substitué,
(c) un groupe naphthyle non-substitué,
(d) un groupe phényle ayant un groupe sélectionné à partir du groupe comportant un groupe nitro, un groupe alkoxy ayant un maximum de 5 atomes de carbone et un atome d'halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_C$ est un groupe sélectionné à partir du groupe consistant des groupes suivants (f) à (k)
(f) un groupe alcoyle ayant un maximum de 10 atomes de carbone,
(g) un groupe phényle non-substitué,
(h) un groupe naphthyle non-substitué,
(i) un groupe phényle comportant un groupe sélectionné à partir du groupe consistant d'un groupe nitro, un groupe alkoxy, et d'un atome halogène, et
(j) un groupe naphthyle comportant un groupe sélectionné à partir du groupe consistant d'un groupe nitro, un groupe alkoxy, et d'un atome halogène, et
(k) un groupe alkoxy comportant un groupe ayant un maximum de 5 atomes de carbone, et $\ell$ est un nombre entier tel que $2 \leqq \ell \leqq 10$.

**15.** Résine photosensible selon la revendication 11, dont ledit membre terminal polysilanyle est de formule suivante

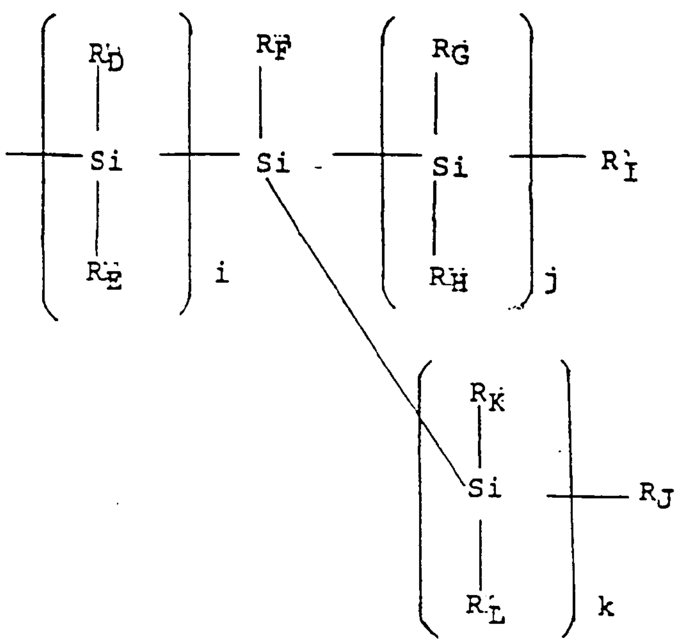

selon laquelle $R_D$, $R_E$, $R_F$, $R_G$, $R_H$, $R_K$ et $R_L$ respectivement sont un groupe sélectionné à partir du groupe consistant des groupes suivants (a) à (e)

(a) un groupe alcoyle linéaire, ramifié ou cyclique ayant un maximum de 10 atomes de carbone,
(b) un groupe phényle non-substitué,
(c) un groupe naphthyle non-substitué,
(d) un groupe phényle prévoyant un groupe sélectionné à partir du groupe consistant d'un groupe nitro, d'un groupe alkoxy ayant un maximum de 5 atomes de carbone, et un atome halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_I$ et $R_J$ respectivement sont un groupe consistant des groupes suivants (f) à (k)
(f) un groupe alcoyle avec un maximum de 10 atomes de carbone,
(g) un groupe phényle non-substitué,
(h) un groupe naphthyle non-substitué,
(i) un groupe phényle comportant un groupe sélectionné à partir du groupe consistant d'un groupe nitro,

un groupe alkoxy, et d'un atome halogène, et
(j) un groupe naphthyle comportant un groupe sélectionné à partir du groupe consistant d'un groupe nitro, un groupe alkoxy, et d'un atome halogène, et
(k) un groupe alkoxy comportant un groupe ayant un maximum de 5 atomes de carbone, et i, j, et k sont des nombres entiers de façon telle que $0 \leqq i \leqq 7$, $1 \leqq j \leqq 8$, $1 \leqq k \leqq 8$ et $i + j + k \leqq 9$.

**16.** Résine photosensible selon la revendication 11, dont ledit dérivé poly(siloxane) est obtenu à partir d'un dérivé linéaire de poly(siloxane) à hydroxyle terminal ayant un poids moléculaire moyen de l'ordre de 2 000 à 100 000.

**17.** Résine photosensible selon la revendication 1, dont ledit dérivé poly(siloxane) est de formule suivante

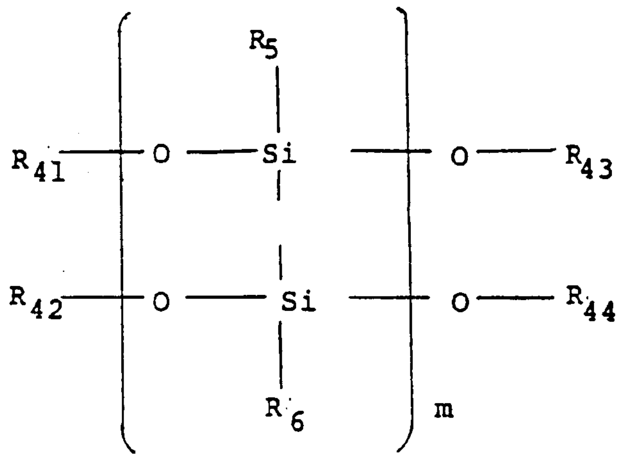

dont $R_{41}$, $R_{42}$, $R_{43}$ et $R_{44}$ sont respectivement un groupe polysilanyle, $R_5$ et $R_5$ sont respectivement un membre sélectionné à partir du groupe consistant d'un groupe non saturé, un groupe alcoyle et un groupe alcoyle halogéné, m étant un nombre entier positif.

**18.** Résine photosensible selon la revendication 17, dont un membre au minimum est un groupe non-saturé sélectionné à partir du groupe consistant d'un groupe vinyle, un groupe allyle, un groupe isopropényle et un groupe 2-butényle.

**19.** Résine photosensible selon la revendication 17, dont un membre au minimum est un groupe alcoyle sélectionné à partir du groupe consistant d'un groupe méthyle, un groupe éthyle, un groupe n-propyle, un groupe isopropyle, un groupe n-butyle, un groupe isobutyle et un groupe tert-butyle.

**20.** Résine photosensible selon la revendication 17, dont un membre au minimum.est un groupe alcoyle halogéné sélectionné à partir du groupe consistant d'un groupe chlorométhyle, un groupe chloroéthyle, un groupe chloropropyle, un groupe chlorobutyle, un groupe bromométhyle, un groupe bromoéthyle, un groupe bromopropyle, un groupe bromobutyle, un groupe iodométhyle, un groupe iodoéthyle, un groupe iodopropyle et un groupe iodobutyle.

**21.** Résine photosensible selon la revendication 17, dont ledit groupe terminal polysilanyle est de formule suivante

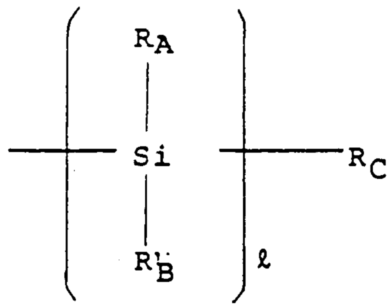

dont $R_A$ et $R_B$ respectivement sont un groupe sélectionné à partir du groupe consistant des groupes suivants (a) à (e)

(a) un groupe alcoyle linéaire, ramifié ou cyclique ayant un maximum de 10 atomes de carbone,
(b) un groupe phényle non-substitué,
(c) un groupe naphthyle non-substitué,
(d) un groupe phényle comportant un groupe sélectionné à partir du groupe consistant d'un groupe nitro, un groupe alkoxy avec un maximum de 5 atomes de carbone, et un atome halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_C$ est un groupe sélectionné à partir du groupe consistant des groupes suivants (f) à (k)
(f) un groupe alcoyle ayant un maximum de 10 atomes de carbone,
(g) un groupe phényle non-substitué,
(h) un groupe naphthyle non-substitué,
(i) un groupe phényle comportant un groupe sélectionné à partir du groupe consistant d'un groupe nitro, un groupe alkoxy, et d'un atome halogène, et
(j) un groupe naphthyle comportant un groupe sélectionné à partir du groupe consistant d'un groupe nitro, un groupe alkoxy, et d'un atome halogène, et
(k) un groupe alkoxy ayant un maximum de 5 atomes de carbone, et $\ell$ est un nombre entier tel que $2 \leqq \ell \leqq 10$.

**22.** Résine photosensible selon la revendication 17, dont ledit groupe terminal polysilanyle est de formule suivante

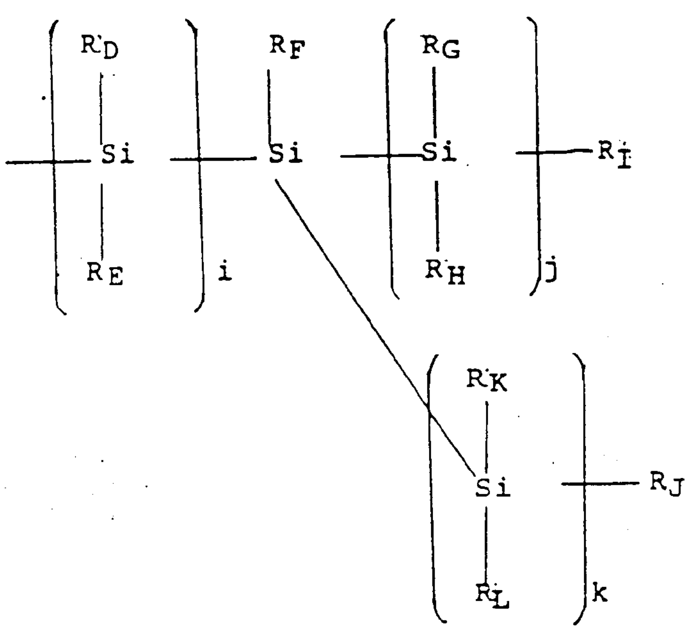

selon laquelle $R_D$, $R_E$, $R_F$, $R_G$, $R_H$, $R_K$ et $R_L$ respectivement sont un groupe sélectionné à partir du groupe consistant des groupes suivants (a) à (e)

(a) un groupe alcoyle linéaire, ramifié ou cyclique comportant un maximum de 10 atomes de carbone,

(b) un groupe phényle non-substitué,
(c) un groupe naphthyle non-substitué,
(d) un groupe phényle prévoyant un groupe sélectionné à partir du groupe consistant d'un groupe nitro, d'un groupe alkoxy ayant un maximum de 5 atomes de carbone, et un atome halogène, et
(e) un groupe naphthyle comportant un groupe sélectionné à partir du groupe consistant d'un groupe nitro, un groupe alkoxy ayant un maximum de 5 atomes de carbone, et d'un atome halogène, $R_I$ et $R_J$ respectivement sont un groupe sélectionné à partir du groupe consistant des groupes suivants (f) à (k)
(f) un groupe alcoyle avec un maximum de 10 atomes de carbone,
(g) un groupe phényle non-substitué,
(h) un groupe naphthyle non-substitué,
(i) un groupe phényle ayant un groupe sélectionné à partir du groupe consistant d'un groupe nitro, un groupe alkoxy, et d'un atome halogène,
(j) un groupe naphthyle ayant un groupe sélectionné à partir du groupe consistant d'un groupe nitro, un groupe alkoxy, et d'un atome halogène, et
(k) un groupe alkoxy ayant un maximum de 5 atomes de carbone, et dont i, j, et k représentent une série de nombres entiers de façon telle que $0 \leqq i \leqq 7$, $1 \leqq j \leqq 8$, $1 \leqq k \leqq 8$ et $i + j + k \leqq 9$.

**23.** Résine photosensible selon la revendication 17, dont ledit dérivé poly(siloxane) est obtenu à partir d'un dérivé polysilsesquioxane linéaire à terminaison hydroxyle de poids moléculaire moyen de l'ordre de 2 000 à 100 000.